# EUROPEAN PATENT APPLICATION

(11) **EP 4 382 306 A1**
(43) Date of publication of application: **12.06.2024**
(21) Application number: 22212105.5
(22) Date of filing: 08.12.2022
(51) Int. Cl.: B41M 1/06, B41F 33/00

(54) **LITHOGRAPHIC PRINTING PRESS MAKE-READY METHOD**

(71) Applicant: ECO3 BV, 2640 Mortsel (BE)
(72) Inventor: BILLIET, Thomas, 2640 Mortsel (BE); CORTENS, Willem, 2640 Mortsel (BE)
(74) Representative: De Clercq & Partners

(57) **Abstract**

A method for setting up a lithographic printing press is provided which allows to reduce the amount of waste copies that is created during the press make-ready time. The method provides the use of paper that was already used in the press make-ready process of a previous print run and includes a first color bar (CB-01'); the method includes the step of exposing a second color bar (CB-02) at a position on the printed copies which is different from the position of the first color bar.

## Description

### TECHNICAL FIELD

The invention relates to an improved method for starting and adjusting a lithographic printing press until it produces sellable copies.

### BACKGROUND ART

Lithographic printing typically involves the use of a so-called printing master such as a printing plate which is mounted on a cylinder of a sheet-fed or web-fed printing press. The master carries a lithographic image on its surface and a print is obtained by applying ink to said image and then transferring the ink from the master onto a receiver material, which is typically paper. In conventional lithographic printing, ink as well as an aqueous liquid called dampening solution are supplied to the lithographic image which consists of oleophilic (or hydrophobic, i.e. ink-accepting, water-repelling) areas as well as hydrophilic (or oleophobic, i.e. water-accepting, ink-repelling) areas. In offset printing, the lithographic plate is mounted on a plate cylinder onto which ink and dampening solution is supplied by the inking system and dampening system of the press and the ink that is accepted by the lithographic image is transferred via an intermediate carrier called the blanket cylinder onto an ink receiving material such as paper. The only exception to the above principles is driographic (also called waterless) printing : this printing technique requires a special type of plate wherein silicones are the major component of the coating. Silicones are so strongly ink-repelling that no water is needed to produce good prints.

Lithographic printing masters are generally obtained by the image-wise exposure and processing of a printing plate precursor (also referred to as "plate material" or briefly as "plate"), which contains a heat- or light-sensitive coating on a substrate. The coating of the printing plate precursor is exposed image-wise to heat or light, typically by means of a digitally modulated exposure device such as a laser, which triggers a (physico-)chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer.

Although some printing plate precursors are capable of producing a lithographic image immediately after exposure, the most popular plate materials require wet processing with a developer since the exposure produces a difference of solubility or of rate of dissolution in a developer between the exposed and the non-exposed areas of the coating. In positive working printing plate precursors, the exposed areas of the coating dissolve in the developer while the non-exposed areas remain resistant to the developer. In negative working printing plate precursors, the non-exposed areas of the coating dissolve in the developer while the exposed areas remain resistant to the developer.

Most lithographic plate precursors contain a hydrophobic coating on a hydrophilic support, so that the areas which remain resistant to the developer define the ink-accepting, hence printing areas of the plate while the hydrophilic support is revealed by the dissolution of the coating in the developer at the non-printing areas.

Some thermal processes enable plate making without wet processing and are for example based on ablation of one or more layers of the coating. At the exposed areas the surface of an underlying layer is revealed which has a different affinity towards ink or fountain than the surface of the unexposed coating; the image (printing) and non-image or background (non-printing) areas are obtained.

The most popular heat-sensitive (thermal) printing plates form an image by a heat-induced solubility difference in an alkaline developer between exposed and non-exposed areas of the coating. The coating typically comprises an oleophilic binder, e.g. a phenolic resin, of which the rate of dissolution in the developer is either reduced (negative working) or increased (positive working), by the image-wise exposure. During processing, the solubility differential leads to the removal of the non-image (non-printing) areas of the coating, thereby revealing the hydrophilic support, while the image (printing) areas of the coating remain on the support. Typical examples of such plates are described in e.g. EP 625 728, EP 823 327, EP 825 927, EP 864 420, EP 894 622 and EP 901 902. Negative working embodiments of such thermal materials often require a pre-heat step between exposure and development as described in e.g. EP 625 728.

Negative heat-sensitive (thermal) printing plates which do not require a pre-heat step may contain an image-recording layer that works by heat-induced particle coalescence of thermoplastic polymer particles, as described in e.g. EP 770 494, 770 495, 770 496 and 770 497. These patents disclose a method for making a lithographic printing plate comprising the steps of (1) image-wise exposing a plate precursor having a heat-sensitive image-recording layer to infrared radiation, wherein said image-recording layer comprises hydrophobic thermoplastic polymer particles, sometimes also referred to as latex particles, which are dispersed in a hydrophilic binder, and (2) developing the image-wise exposed element. During the development step, the unexposed areas of the image-recording layer are removed from the support, whereas the latex particles in the exposed areas have coalesced to form a hydrophobic phase which is not removed in the development step. It is known in the art that lithographic plates, obtained after exposure, development and optional gumming, can be heat-treated in a so-called post-baking step in order to increase the presslife of the plate on the press. A typical post-baking is carried out by heating the plate in an oven at a high temperature, e.g. of about 250 °C as described in for example EP 1 506 854.

Another popular type of lithographic printing plate precursors are so-called photopolymer printing plates which usually comprise a negative-working image recording layer and often a protective overcoat. Upon image-wise exposure to light or heat, the image recording layer undergoes a chemical reaction whereby the layer hardens, i.e. becomes insoluble or non-dispersible in the developing solution through photopolymerization and/or photocrosslinking. Photopolymer plates which work by free-radical polymerization or crosslinking typically contain an overcoat which also acts as an oxygen barrier layer which increases the sensitivity of the plate by reducing the quenching by oxygen of the free radicals that are generated in the image recording layer by the image-wise exposure. The overcoat also protects the image recording layer from scratching and/or contamination.

The conventional method of making photopolymer printing plates comprises first an image-wise exposure step of the plate precursor with a laser, followed by an optional "pre-heat" step to enhance the polymerization and/or crosslinking reaction of the radicals which have been generated in the image recording layer by the exposure, a wash step to remove the protective overcoat, an alkaline developing step to remove unexposed areas of the image recording layer, and a rinse and gum step.

An important trend in lithographic platemaking is related to ecology and sustainability. Systems and methods which enable a low consumption of processing liquids such as developer, rinse water and gum solution, or which allow processing with aqueous developers comprising no hazardous chemicals and/or which have a pH close to 7 (neutral developer), have attracted a lot of attention in the marketplace. A convenient method which has become popular involves the use of a gum solution as developer, whereby the plate is developed and gummed in a single step as described in e.g. EP 1 342 568 and WO 2005/111727.

More recently, on-press processing wherein the plate is mounted on the press and the image is developed by interaction with the ink and/or the dampening solution that are supplied to the plate during the start of the printing press, has attracted interest in the market. Plate precursors which are especially designed for on-press processing are sometimes designated as "process-free" or "DOP" (Development On Press) plates. During the press start, DOP plates develop a lithographic image because the non-printing areas of the coating are removed by the ink and/or by the dampening solution while the printing areas are resistant thereto.

In a typical printing process, a lithographic printing plate for each color selection, typically Cyan, Magenta, Yellow, and blacK (CMYK) is mounted on the plate cylinder of the corresponding print station of a printing press. The press operator can adjust the amount of ink that is supplied across the width of the plate cylinder by adjusting the ink keys of each print station during the so-called "press make-ready" process. Make-ready is a term which defines all the operations necessary to start and set up a printing press until it produces sellable copies. Installing a new set of printing plates and adjusting the press to the print run takes several minutes, depending on the degree of automation of the particular press and the skill of the operator. As a result, a substantial number of printed copies is lost during the press make-ready process which is typically a few hundred, or even more than five hundred in some print runs such as those wherein for example UV-curable ink is used.

From both an economically and ecologically point of view, there is a growing interest in the market to reduce the huge amount of these waste copies. Moreover, in view of the competition with digital printing techniques, such as inkjet printers which immediately print at production quality, reduction of these waste copies is of high interest in the market.

### SUMMARY OF INVENTION

It is therefore an object of the present invention to provide a method of setting up a lithographic printing press for a new print run whereby the number of waste copies is significantly reduced. This object is realized by the method defined in claim 1, i.e. a method for setting up a lithographic printing press for a new print run wherein sheets which have already been printed in the process of preparing the press for printing in a previous print run and thus typically include an image and at least one color bar, are re-used. As a result, much less waste paper is generated during the process of printing at least two print runs. The method comprises the steps of
(a) preparing a printing plate precursor by exposing an image in an area of the lithographic printing plate precursor, and a color bar CB-02 outside said area;
(b) mounting the exposed plate precursor on the plate cylinder of the printing press;
(c) carrying out a make-ready process for bringing the printing press to production quality which is defined by target color data on printed copies produced by the printing press, said press make-ready process comprising the steps of
   (c-i) feeding a number of sheets through the printing press thereby producing printed copies of the image and of the color bar CB-02;
   (c-ii) measuring color data on the printed copies of the color bar and adjusting the inking system in accordance with the difference between the measured color data and the target color data;
   (c-iii) repeating step (c-i and c-ii) until the measured color data match the target color data;
   wherein the sheets which are fed through the printing press in step (c-i) are sheets which have already been used in the press make-ready process of another print run and include at least a previous color bar CB-01 at a position on the printed copies which is different from the position of the color bar CB-02 exposed in step (a).

The color bars CB-01 and CB-02 are preferably printed on the same side of the sheets.

Other features, elements, steps, characteristics and advantages of the present invention will become more apparent from the following detailed description of preferred embodiments of the present invention. Specific embodiments of the invention are also defined in the dependent claims.

### BRIEF DESCRIPTION OF DRAWINGS

Figure 1 shows a printed sheet (1) obtained after two print runs by the method of the present invention.
Figure 2 shows another printed sheet (1) obtained after three print runs by the method of the present invention,
Figure 3 is a presentation of four subsequent print runs using the same paper.

It should be noted that the figures represent grayscale images, due to the technical requirements of patent applications documents. Therefore, the figures do not represent the full scope of the invention, since it can be used in black-and-white printing as well as color printing; in the latter embodiment, the color bars comprise multiple color patches in order to allow ink key adjustment of the various print stations of the press.

### DESCRIPTION OF PREFERRED EMBODIMENTS

### Press make-ready process

The printing press can be a single-color or a multi-color press which comprises a plurality of color stations. A single-color printing press includes at least one print station which comprises an inking system and a plate cylinder. A multi-color color printing press may contain two to six or even up to twelve print stations but typically contains four print stations. Full-color printing requires the preparation of a lithographic plate for each color selection, typically Cyan, Magenta, Yellow, and blacK (CMYK) and optionally other combinations. Each printing plate is mounted on the plate cylinder of the corresponding print station of the press. The press operator can adjust the amount of ink that is supplied across the width of the plate cylinder by adjusting the ink keys of each print station during the so-called "press make-ready" process. The press make-ready process involves all the operations necessary to start and set up a printing press until it produces sellable copies.

A typical inking system of a lithographic press comprises a train of a plurality of rollers which supply the ink from an ink reservoir to the plate. At the beginning of a print run, the press needs to be adjusted to reach production quality - i.e. the target color data - on the printed copies produced by the press. The measured color data match the target color data when the measured color and the target color is within an accepted tolerance, e.g. the ΔE deviation defined in ISO standard 12647-2 (2013).

This color measurement process is preferably carried out by an automatic press control system which enables to measure color data on the printed copy and to modify said color data on the printed copies by adjusting the inking system.

Indeed, in a conventional press make-ready procedure, the initial setting of the ink keys is selected in accordance with the image on the plate (more printing areas require more ink) and with the known relation between the amount of the ink supply and the color density obtained on the printed copies. Said relation depends on the specific combination of a given receiver material - e.g. paper (such as the level of absorbing ink, uncoated paper, coated paper such as matte paper, gloss paper, silk paper, bond paper, etc), card stock, card board, vinyl, textile etc-, type of colorant, type of screening and type of ink - such as for example UV curable inks, LED curable inks, electron beam (EB) curable inks, oxidising inks etc -, which may be called a standard printing condition. Standard printing conditions are usually collected by color measurements on the press which has been carefully set up to that specific printing condition and/or on the basis of artificial intelligence. In spite of these known relations between ink supply and color density, it is still necessary to adjust the inking system once the press has started, because each print run has a different lithographic image. As a result, the press make-ready process involves additional fine-tuning of the ink supply for that particular image in order to obtain a stable setting which produces a color density on the printed copies that matches the target color density, meaning that the difference between the measured color and the target color is within an accepted tolerance, e.g. the ΔE deviation defined in ISO standard 12647-2 (2013).

The adjustment of the ink keys is typically controlled by measuring a color bar, which is exposed on the printing plate precursor outside the image area. Such a color bar typically consists of a strip of grayscale and color patches, often shaped as squares, which are arranged side by side outside the image area for example positioned perpendicular (in the feeding direction) to the axis of the plate cylinder of the press, or along the direction parallel to the axis of the plate cylinder. The color bar is preferably arranged along the direction parallel to the axis of the plate cylinder. The color bar is preferably printed together with the image on the printed copies and can be measured after the print run on the printed copies, e.g. by the press operator removing a printed copy from the press and measuring the color of the patches with a densitometer, by an off-press (digital) scanning device, and/or automatically by a digital scanning device or automatic press control system that is installed on the press itself. Such an automatic press control system preferably includes an integrated system to detect and to measure a color bar. The color bar preferably further includes predefined "patches" - also called "recognition patches" - which enable the digital scanning device or automatic press control system to detect the position of the color bar on the printed copies in order to be able to measure the color data and adjust the inking system. Such recognition patches also including for example a bar code, a QR code, etc - may be positioned on the color bar at any position. The color bar may include one or more than one set of recognition patches, for example separate recognition patches for each color, eg CMYK.

Alternatively, detection of the color bar and/or of the recognition patches of the color bar by the automatic press control system may be on the basis of specific coordinates defining the position of the color bar on the printed sheets.

The measured color data can then be used to adjust the keys of the inking system in order to modify the amount and the lateral distribution of the ink across the plate cylinder and that procedure is repeated until production quality (sellable copies) is obtained. Said color data may be densitometric (color density) or colorimetric (L*, a*, b*) data. Examples of fully automated systems are described in e.g. US6024018 and US2006/0170996.

According to the method of the present invention, the make-ready process for bringing the printing press to production quality comprises the step of re-using sheets that were already used in the press make-ready process of one or more earlier print runs. The sheets which were used in one or more earlier print runs contain at least one image and at least one color bar.

The method comprises the step of starting a print run by feeding a number of sheets which were used in at least one previous print run and thus include at least one image and at least one color bar, through the printing press. Printed copies are produced including (i) at least one image that was printed in the previous print run and an image that is printed in the current print run and (ii) at least two color bars i.e. a color bar that was printed in the previous print run also referred to as "the previous color bar" or CB-01; and a color bar printed in the current print run, also referred to as "the current color bar" or CB-02.

The color bar on the printed sheets that was used in the previous print run for the make-ready process should be deactivated before the current color bar is detected by the printing press. Typically, the automatic press control system is a device that detects and measures the color bar and is installed at the end of the press, i.e. after the last print station. This implies that the color bar which was printed in the previous print run and which has to be deactivated before detection of the current color bar, should be deactivated at the end of the previous print run - i.e. on press after measuring the color bar or off press- ; or in any print station during the current print run.

Alternatively, the automatic press control system which includes an integrated system to detect and to measure a color bar, may be installed on the printing press as two separate devices i.e. a detection device and a color measuring device. The detection device may be positioned on the printing press at any position between the beginning of the press - e.g. before the first print station - and the end of the press - e.g. after the last print station. The color measurement device is generally positioned after the last print station of the printing press. In this embodiment, deactivation of the color bar which was printed in the previous print run may be performed :
(i) during the previous print run at any position on the press i.e. in any print station including for example print stations to apply PMS colors, varnishes, etc or a print station specifically dedicated to deactivate a color bar; provided that the color bar is detected by the detection device before its deactivation, or
(ii) during the current print run at any position on the press i.e. in any print station, with the proviso that the previous color bar is deactivated before that the current color bar is detected by the detection device.

Deactivation of a (previous) color bar during a print run is preferably performed by exposing in step (a) an image - also referred to as a "deactivation image" - on the printing plate precursor at the position which corresponds to the position of the (previous) color bar on the printed sheets. The deactivation image may cover the full color bar or at least the predefined "recognition patches" of the color bar. The deactivation image may have any pattern, e.g. longitudinal strokes, traverse stripes, circular, rectangular, triangular and/or oval marks and/or any other form or figure. In the embodiment where the printing press includes for example four print stations, the deactivation image is preferably exposed on one of the four printing plate precursors that were prepared for each print station, at the position which corresponds to the position of the printed color bar to be deactivated. The (previous) color bar may be deactivated in any print station including for example print stations to apply PMS colors, varnishes, etc, and/or by means of a deactivation device - e.g. a device including an inkjet printhead or a print station specifically dedicated to deactivate a color bar - that may be installed throughout the printing press; with the proviso that the (previous) color bar is deactivated before that the current color bar is detected.

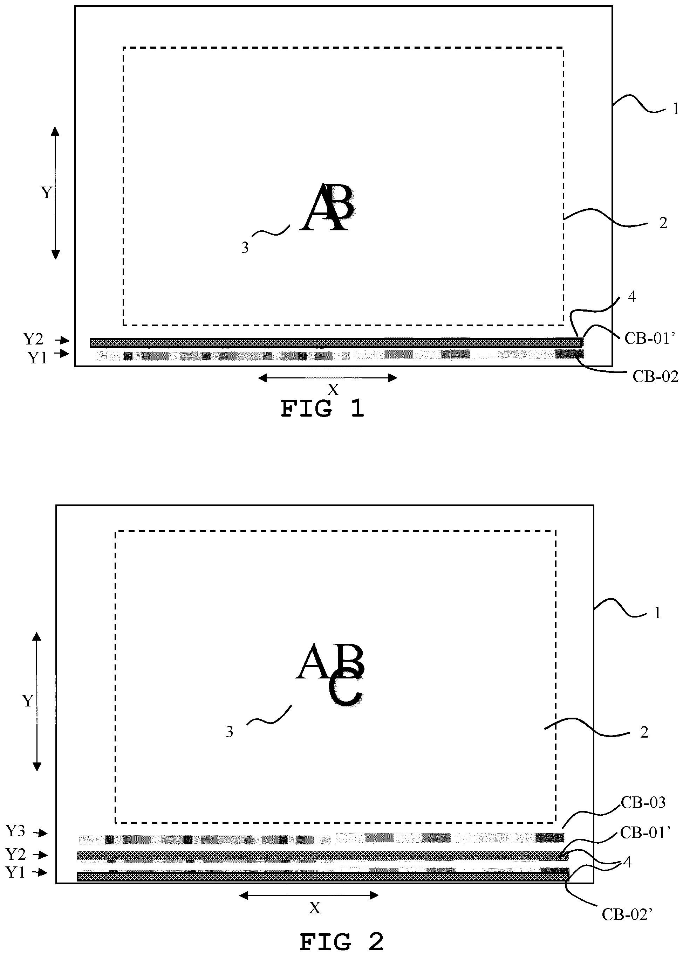

Figure 1 shows an example of a printed sheet (1) obtained after two print runs by the method of the present invention. Sheet (1) has a printed copy of two images (3) respectively printed in the first and the second print run inside an image area (2) and a printed copy of two color bars (CB-1) and (CB-2) respectively printed in the first and the second print run and at respective positions (Y1) and (Y2) along direction (X) parallel to the axis of the plate cylinder. One of the color bars has been deactivated (CB-1': the apostrophe indicating the deactivation) by a deactivation image (4) on top of the printed copy of said color bar and wherein the remaining printed color bar (CB-2) is used for the make-ready process of the printing press.

Deactivation of a color bar at the end of a print run_may be performed by applying a deactivation image on the printed copies by hand and/or by means of a separate deactivation device - e.g. a device including an inkjet printhead - that may be installed as an off-press device.

Furthermore, deactivation of a color bar may be performed by for example modifying the coördinates defining the position of the color bar on the printed sheets. Modifying the coordinates of the position of the color bar can for example be obtained by moving the register of the press mechanically.

The invention is not limited to the single re-use of printed sheets, the sheets may be re-used more than once, for example two re-uses whereby a third color bar is exposed outside the image area or further re-uses where even more than three color bars are exposed outside the image area. The number of re-use of the printed sheets is not limited, however, the ink load on the printed sheets is preferably not too high in order to remain a workable press make-ready process. The deactivation of the color bars used in the previous print runs is preferably performed following the options as explained in detail above.

Figure 2 shows an example of a printed sheet (1) obtained after three print runs by the method of the present invention. Sheet (1) has a printed copy of three images (3) respectively printed in the first, the second and the third print run inside an image area (2) and a printed copy of three color bars respectively printed in the first, the second and the third print run and at respective positions (Y1), (Y2) and (Y3) along direction (X) parallel to the axis of the plate cylinder. Two color bars (CB-1') and (CB-2') (the apostrophe indicating the deactivation) have been deactivated by a deactivation image (4) on top of the printed copy of said color bars and wherein the remaining printed color bar (CB-3) is used for the make-ready process of the printing press.

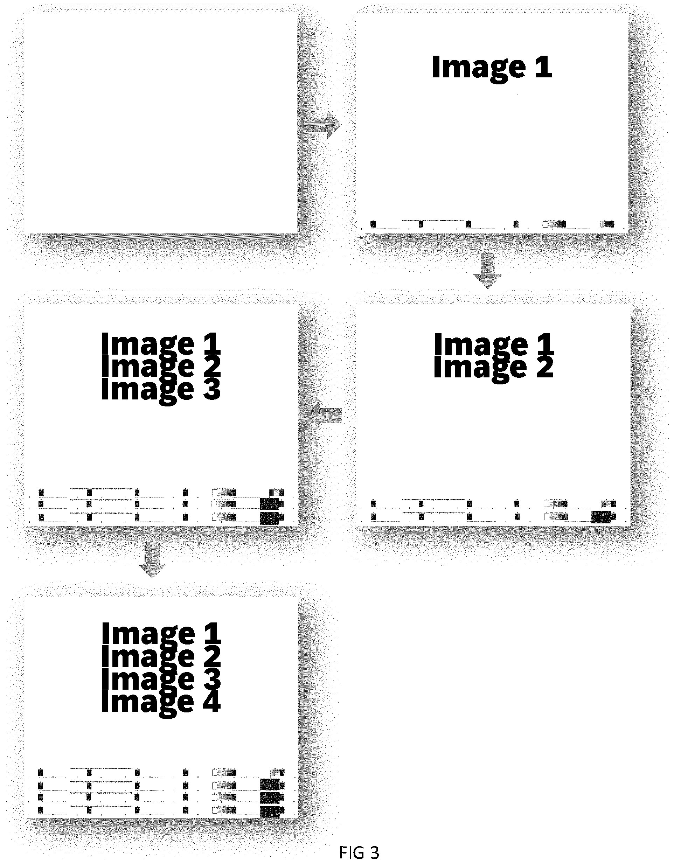

Figure 3 shows a scheme of four printing runs according to the present invention, using the same paper:
in run 1, Image 1 and one color bar were printed,
in run 2, Image 2 was printed on top of Image 1 and a second color bar at a position which is different from color bar 1 was printed, and the first color bar was deactivated by applying a black stroke on its recognition patches,
in run 3, Image 3 was printed on top of Images 1 and 2; and a third color bar at a position which is different from color bars 1 and 2 was printed, and the second color bar was deactivated by applying black stroke on its recognition patches,
in run 4, Image 4 was printed on top of Images 1, 2 and 3; and a fourth color bar at a position which is different from color bars 1, 2 and 3 was printed, and the third color bar was deactivated by applying a black stroke on its recognition patches.

### Definitions

The term "aryl" herein is preferably phenyl, benzyl, tolyl, ortho- meta- or para-xylyl, naphthyl, anthracenyl, phenanthrenyl, and/or combinations thereof. The heteroaryl group is preferably a monocyclic or polycyclic aromatic ring comprising carbon atoms and one or more heteroatoms in the ring structure, preferably 1 to 4 heteroatoms, independently selected from nitrogen, oxygen, selenium and sulfur. Preferred examples thereof include an optionally substituted furyl, pyridinyl, pyrimidyl, pyrazoyl, imidazoyl, oxazoyl, isoxazoyl, thienyl, tetrazoyl, thiazoyl, (1,2,3)triazoyl, (1,2,4)triazoyl, thiadiazoyl, thiophenyl group and/or combinations thereof. The optionally substituted heteroaryl is preferably a five- or six-membered ring substituted by one, two or three oxygen atoms, nitrogen atoms, sulfur atoms, selenium atoms or combinations thereof. Examples thereof include furan, thiophene, pyrrole, pyrazole, imidazole, 1,2,3-triazole, 1,2,4-triazole, tetrazole, oxazole, isoxazole, thiazole, isothiazole, thiadiazole, oxadiazole, pyridine, pyridazine, pyrimidine, pyrazine, 1,3,5-triazine, 1,2,4-triazine or 1,2,3-triazine, benzofuran, benzothiophene, indole, indazole, benzoxazole, quinoline, quinazoline, benzimidazole or benztriazole.

The term "alkyl" herein means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methylbutyl, etc. Preferably, the alkyl group is a C₁ to C₂₀-alkyl group; more preferably the alkyl group is a C₁ to C₆-alkyl group. Most preferably the alkyl is a methyl group. Cycloalkyls include for example, substituted or unsubstituted cyclopropyl, cyclopentyl, cyclohexyl, 4-methylcyclohexyl, and cyclooctyl groups.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

The optional substituents represent an alkyl, cycloalkyl, alkenyl or cycloalkenyl group, an alkynyl group, an aryl or heteroaryl group, an alkylaryl or arylalkyl group, an alkoxy group such as methoxy, ethoxy, iso-propoxy, t-butoxy, (2-hydroxytetradecyl)oxy, and various other linear and branched alkyleneoxyalkoxy groups; an aryloxy group, a thio alkyl, thio aryl or thio heteroaryl group, a hydroxyl group, -SH, a carboxylic acid group or an alkyl ester thereof, a sulfonic acid group or an alkyl est2.5er thereof, a phosphonic acid group or an alkyl ester thereof, a phosphoric acid group or an alkyl ester thereof, an amino group, a sulfonamide group, an amide group, a nitro group, a nitrile group, a halogen such as fluoro, chloro, or bromo, or a combination thereof.

A suitable alkenyl group herein is preferably a C₂ to C₆-alkenyl group such as an ethenyl, n-propenyl, n-butenyl, n-pentenyl, n-hexenyl, iso-propenyl, iso-butenyl, iso-pentenyl, neo-pentenyl, 1-methylbutenyl, iso-hexenyl, cyclopentenyl, cyclohexenyl and methylcyclohexenyl group.

A suitable alkynyl group herein is preferably a C₂ to C₆-alkynyl group; a suitable aralkyl group is preferably a phenyl group or naphthyl group including one, two, three or more C₁ to C₆-alkyl groups; a suitable aralkyl group is preferably a C₁ to C₆-alkyl group including an aryl group, preferably a phenyl group or naphthyl group.

A cyclic group or cyclic structure herein includes at least one ring structure and may be a monocyclic- or polycyclic group, meaning one or more rings fused together.

A print station: a unit of a printing press which is used for printing one color; a lithographic color station normally comprises a plate cylinder for carrying a printing master and an inking system.

### Printing plate precursors

The lithographic printing plate precursor preferably comprises an imageable coating on a hydrophilic support. The imageable coating comprises an image recording layer which may be positive- or negative-working i.e. can form ink-accepting areas at exposed or at non-exposed areas respectively. The coating may further include other layers such as for example an intermediate layer, located between the support and the image recording layer and/or between the top layer and the image recording layer, an adhesion improving layer, a hydrophilizing layer and/or other layers.

Below, the preferred supports and suitable, non limiting examples of heat- and light-sensitive coatings are discussed in detail below.

### Support

The support preferably has a hydrophilic surface or is provided with a hydrophilic layer. The support may be a sheet-like material such as a plate or it may be a cylindrical element such as a sleeve which can be slid around a print cylinder of a printing press. The support is preferably a metal support such as aluminum or stainless steel. The metal can also be laminated to a plastic layer, e.g. polyester film. According to another embodiment, the support can also be a flexible support, which is provided with a hydrophilic layer such as for example a hydrophilic binder cross-linked with a hardening agent such as formaldehyde, glyoxal, polyisocyanate or a hydrolyzed tetra-alkylorthosilicate. The flexible support is for example paper, plastic film, thin aluminum or a laminate thereof. Preferred examples of plastic film are polyethylene terephthalate film, polyethylene naphthalate film, cellulose acetate film, polystyrene film, polycarbonate film, etc. The plastic film support may be opaque or transparent.

Most preferred is a grained and anodized aluminum support, well known in the art. Suitable supports are for example disclosed in EP1843203 (paragraphs [0066] to [0075]). The surface roughness obtained after the graining step, expressed as arithmetical mean center-line roughness Ra (ISO 4287/1 or DIN 4762), may vary between 0.05 and 1.5 µm, more preferably from 0.3 to 0.6 µm. By anodizing the aluminum support, an Al₂O₃ layer is formed of which the weight (g/m² Al₂O₃) may vary between 1 and 8 g/m², more preferably between 2 and 3 g/m².

The grained and anodized aluminum support may be subjected to a so-called post-anodic treatment and/or a pore widening treatment. Suitable examples of post-anodic treatment are treatments with poly(vinylphosphonic acid) or derivatives thereof, with poly(acrylic acid), with potassium fluorozirconate or a phosphate, with an alkali metal silicate, or combinations thereof. Alternatively, the support may be treated with an adhesion promoting compound such as those described in EP1788434 in [0010] and in WO 2013/182328.

### Heat-sensitive printing plate precursors

The imaging mechanism of the heat-sensitive printing plate precursors can be triggered by direct exposure to heat, e.g. by means of a thermal head, or by the light absorption of one or more compounds in the coating that are capable of converting light, more preferably infrared light, into heat. Suitable examples of such compounds include pigments such as carbon black and/or more preferably an IR dye which may be added to the image-recording layer and/or to an optional other layer. These heat-sensitive lithographic printing plate precursors are preferably not sensitive to visible light, i.e. no substantial effect on the dissolution rate of the coating in the developer is induced by exposure to visible light. Most preferably, the coating is not sensitive to ambient daylight.

### Hydrophobic thermoplastic polymer particles

A first suitable example of a heat-sensitive printing plate precursor is a precursor based on heat-induced coalescence of hydrophobic thermoplastic polymer particles which are preferably dispersed in a hydrophilic binder, as described in e.g. EP 770 494, EP 770 495, EP 770 497, EP 773 112, EP 774 364, EP 849 090, EP 1 614 538, EP 1 614 539, EP 1 614 540, EP 1 777 067, EP 1 767 349, WO 2006/037716, WO 2006/133741 and WO 2007/045515.

Specific examples of suitable hydrophobic thermoplastic polymers are e.g. polyethylene, poly(vinyl chloride), poly(methyl (meth)acrylate), poly(ethyl (meth)acrylate), poly(vinylidene chloride), poly(meth)acrylonitrile, poly(vinyl carbazole), polystyrene or copolymers thereof. Polystyrene and poly(meth)acrylonitrile or their derivatives which preferably comprise at least 50 wt.% of polystyrene, and more preferably at least 60 wt.% of polystyrene are highly preferred embodiments. In order to obtain sufficient resistivity towards organic chemicals, such as the hydrocarbons used in plate cleaners, the thermoplastic polymer preferably comprises at least 5 wt.%, more preferably at least 30 wt.% of nitrogen containing monomeric units or of units which correspond to monomers that are characterized by a solubility parameter larger than 20, such as (meth)acrylonitrile. According to the most preferred embodiment, the thermoplastic polymer is a copolymer consisting of styrene and acrylonitrile units in a weight ratio between 1:1 and 5:1 (styrene:acrylonitrile), e.g. in a 2:1 ratio.

Preferably the image-recording layer comprises an organic compound including at least one phosphonic acid group or at least one phosphoric acid group or a salt thereof, as described in WO 2007/04551.

The weight average molecular weight of the thermoplastic polymer particles may range from 5,000 to 1,000,000 g/mol. The hydrophobic particles preferably have a number average particle diameter below 200 nm, more preferably between 10 and 100 nm. The amount of hydrophobic thermoplastic polymer particles contained in the image-recording layer is preferably between 20 wt.% and 65 wt.% and more preferably between 25 wt.% and 55 wt.% and most preferably between 30 wt.% and 45 wt.%.

The thermoplastic polymer particles are preferably dispersed in a hydrophilic binder, which may be selected from for example homopolymers and copolymers of vinyl alcohol, acrylamide, methylol acrylamide, methylol methacrylamide, acrylic acid, methacrylic acid, hydroxyethyl acrylate, hydroxyethyl methacrylate or maleic anhydride/vinylmethylether copolymers. The hydrophilicity of the (co)polymer or (co)polymer mixture used is preferably the same as or higher than the hydrophilicity of polyvinyl acetate hydrolyzed to at least an extent of 60 wt.%, preferably 80 wt.%.

After image-wise exposure, the image recording layer of this embodiment may be developed off-press by means of an aqueous developer. Such embodiments preferably comprise a contrast dye or pigment which provides a visible image after development and may be added to any layer of the imageable coating,.

A preferred developer is a gum solution which is capable of simultaneously developing and gumming the image in a single step as described in EP1342568, or by a cascade configuration as described in for example WO2007/057349.

The image recording layer of this embodiment may also be developed on press with dampening solution and/or ink, i.e. the non-printing areas of the image can be removed by the dampening solution and/or ink that is supplied to the plate by the lithographic printing press. Such embodiments preferably contain a leuco dye or a thermochromic IR dye that produces a visible image immediately upon exposure (i.e. before processing), so that the image can be checked before the plate is mounted on a plate cylinder of the press. Such leuco dye or thermochromic IR dye may be added to any layer of the imageable coating. Preferred thermochromic IR dyes are described in EP1736312. After being mounted on the press, the plate is processed by rotating the plate cylinder while feeding dampening solution and/or ink to the exposed precursor. In a preferred embodiment, only dampening solution is supplied to the plate in the first 60 seconds, more preferably the first 30 seconds and most preferably the first 15 seconds, after the start of the press and then the ink supply is also switched on. In an alternative embodiment, supply of dampening solution and ink can be started simultaneously or only ink can be supplied during a number of revolutions before switching on the supply of dampening solution. Preferred embodiments of the imageable coating require less than 25 printed copies to remove the non-printing areas of the image completely from the substrate.

### Aryldiazosulfonate homo- or copolymer

In a second suitable embodiment, the heat-sensitive printing plate precursor comprises a coating comprising an aryldiazosulfonate homo- or copolymer which is hydrophilic and soluble in the processing liquid before exposure to heat or UV light and rendered hydrophobic and less soluble after such exposure.

Preferred examples of such aryldiazosulfonate polymers are the compounds which can be prepared by homo- or copolymerization of aryldiazosulfonate monomers with other aryldiazosulfonate monomers and/or with vinyl monomers such as (meth)acrylic acid or esters thereof, (meth)acrylamide, acrylonitrile, vinylacetate, vinylchloride, vinylidene chloride, styrene, α-methyl styrene etc. Suitable aryldiazosulfonate monomers are disclosed in EP 339393, EP 507008 and EP 771645 and suitable aryldiazosulfonate polymers are disclosed in EP 507,008, EP 960,729, EP 960,730 and EP1,267,211.

### Positive working heat-sensitive printing plates

A further suitable heat-sensitive printing plate precursor is positive working and relies on heat-induced solubilization of a hydrophobic and/or oleophilic resin. This resin is preferably a polymer that is soluble in an aqueous developer, more preferably an aqueous alkaline development solution with a pH between 7.5 and 14. Preferred polymers are phenolic resins e.g. novolac, resoles, polyvinyl phenols and carboxy substituted polymers. Typical examples of these polymers are described in EP823327 and WO1997/039894.The amount of phenolic resin present in the imaging layer is preferably at least 50% by weight, preferably at least 80% by weight relative to the total weight of all the components present in the imaging layer.

In a preferred embodiment, the hydrophobic or oleophilic resin is a phenolic resin wherein the phenyl group or the hydroxy group is chemically modified with an organic substituent. The phenolic resins which are chemically modified with an organic substituent may exhibit an increased chemical resistance against printing chemicals such as fountain solutions or plate treating liquids such as plate cleaners. Examples of such chemically modified phenolic resins are described in EP 934 822, EP 1 072 432, US 5 641 608, EP 0 982 123, WO 99/01795, EP 02 102 446, EP 02 102 444, EP 02 102 445, EP 02 102 443, EP 03 102 522. The modified resins described in EP 02 102 446, are preferred, especially those resins wherein the phenyl-group of said phenolic resin is substituted with a group having the structure -N=N-Q, wherein the -N=N- group is covalently bound to a carbon atom of the phenyl group and wherein Q is an aromatic group.

Phenolic resins may also be mixed with or replaced by other polymers such as poly(vinyl acetal) resins in order to improve the abrasion resistance of the coating. Preferred poly(vinyl acetal) resins are copolymers comprising acetal moieties and ethylenic moieties as described in WO2014/106554, WO2015/158566 , WO2015/173231, WO2015/189092 and WO2016/001023. Especially preferred poly(vinyl acetale) resins are resins including ethylenic moieties and acetal moieties including an optionally substituted aromatic or heteroaromatic group including at least one hydroxyl group (WO2014/106554), or poly(vinyl acetale) resins including an optionally substituted aromatic or heteroaromatic group are resins including at least one hydroxyl group in ortho or para position relative to an electron withdrawing group (WO2015/158566).

The coating may further comprise a second layer that comprises one or more other binder(s) which is insoluble in water and soluble in an alkaline solution such as an organic polymer which has acidic groups with a pKa of less than 13 to ensure that the layer is soluble or at least swellable in aqueous alkaline developers. This layer is located between the layer described above comprising the hydrophobic or oleophilic resin and the hydrophilic support. The binder may be selected from a polyester resin, a polyamide resin, an epoxy resin, a polyimide, an acrylic resin, a methacrylic resin, a styrene based resin, a polyurethane resin or a polyurea resin. The binder may have one or more functional groups. (Co)polymers including a sulfonamide group are preferred. Sulfonamide (co)polymers are preferably high molecular weight compounds prepared by homopolymerization of monomers containing at least one sulfonamide group or by copolymerization of such monomers and other polymerizable monomers. Examples of monomers copolymerized with the monomers containing at least one sulfonamide group include monomers as disclosed in EP 1 262 318, EP 1 275 498, EP 909 657, EP 1 120 246, EP 894 622, US 5,141,838, EP 1 545 878 and EP 1 400 351.

Suitable examples of sulfonamide (co)polymers and/or their method of preparation are disclosed in EP 933 682, EP 982 123, EP 1 072 432, WO 99/63407, EP 1 400 351 and EP 2 159 049. A highly preferred example of a sulfonamide (co)polymer is described in EP 2 047 988 A in [0044] to [0046].

Specific preferred examples of sulphonamide (co)polymers are polymers comprising N-(p-aminosulfonylphenyl) (meth)acrylamide, N-(m-aminosulfonylphenyl) (meth)acrylamide N-(o-aminosulfonylphenyl) (meth)acrylamide and or m-aminosulfonylphenyl (meth)acrylate.

The dissolution behaviour of the coating can be fine-tuned by optional solubility regulating components. More particularly, developability enhancing compounds, development accelerators and development inhibitors can be used. In the embodiment where the coating comprises more than one layer, these ingredients can be added to the first layer and/or to the second layer and/or to an optional other layer of the coating.

Suitable developability enhancing compounds are (i) compounds which upon heating release gas as disclosed in WO 2003/79113, (ii) the compounds as disclosed in WO 2004/81662, (iii) the compositions that comprises one or more basic nitrogen-containing organic compounds as disclosed in WO 2008/103258 and (iv) the organic compounds having at least one amino group and at least one carboxylic acid group as disclosed in WO 2009/85093. More details concerning developability enhancing compounds are described in WO2017/157575 [0066] to [0077].

Suitable dissolution inhibitors are preferably organic compounds which comprise at least one aromatic group and a hydrogen bonding site which interacts with the hydrophobic or oleophilic, alkali-soluble polymers, e.g. with the hydroxy group of the phenolic resin. Suitable examples of hydrogen bonding sites are a carbonyl group, a sulfonyl group, or a nitrogen atom which may be quaternized and which may be part of a heterocyclic ring or which may be part of an amino substituent of said organic compound. Suitable dissolution inhibitors of this type have been disclosed in e.g. EP823327A and WO1997/039894.

The coating of the heat-sensitive printing plate precursors described above preferably also contains an infrared light absorbing dye or pigment which, in the embodiment where the coating comprises more than one layer, may be present in the first layer, and/or in the second layer, and/or in an optional other layer. Preferred IR dyes have a light absorption peak between 750 nm and 1300 nm, more preferably between 780 nm and 1100 nm, and most preferably between 800 nm and 850 nm. Suitable classes of IR dyes are cyanine dyes, merocyanine dyes, indoaniline dyes, oxonol dyes, pyrilium dyes and squarilium dyes. Examples of suitable IR dyes are described in e.g. EP 823327, EP978376, EP1029667, EP1053868, EP1093934; EP1359008, WO 1997/39894 and 2000/29214.

The concentration of the IR-dye in the coating is preferably between 0.25 and 15.0 %wt, more preferably between 0.5 and 10.0 %wt, most preferably between 1.0 and 7.5 %wt relative to the coating as a whole.

The coating may further comprise one or more colorant(s) such as dyes or pigments which provide a visible color to the coating and which remain in the coating at the image areas which are not removed during the processing step, often called contrast dyes or indicator dyes. Thereby a visible image is formed and examination of the lithographic image on the developed printing plate becomes feasible.

To protect the surface of the coating of the heat and/or light sensitive printing plate precursors, in particular from mechanical damage, a protective layer may also optionally be applied. The protective layer generally comprises at least one water-soluble binder, such as polyvinyl alcohol, polyvinylpyrrolidone, partially hydrolyzed polyvinyl acetates, gelatin, carbohydrates or hydroxyethylcellulose, and can be produced in any known manner such as from an aqueous solution or dispersion which may, if required, contain small amounts - i.e. less than 5% by weight based on the total weight of the coating solvents for the protective layer - of organic solvents. The thickness of the protective layer can suitably be any amount, advantageously up to 5.0 µm, preferably from 0.1 to 3.0 µm, particularly preferably from 0.15 to 1.0 µm.

Optionally, the coating may further contain additional ingredients such as surfactants, especially silicon or perfluoro surfactants, silicon or titanium dioxide particles or polymers particles such as matting agents and spacers.

Any coating method can be used for applying one or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch. However, it is not necessary (and may not even be possible) to remove all the solvent in the drying step. Indeed, the residual solvent content may be regarded as an additional composition variable by means of which the composition may be optimized. Drying is typically carried out by blowing hot air onto the coating, typically at a temperature of at least 70°C, suitably 80-150°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP 1074386, EP 1074889, WO00/29214, and WO/04030923, WO/04030924, WO/04030925.

The printing plate precursor can be exposed to infrared light by means of e.g. LEDs or a laser. Most preferably, the light used for the exposure is a laser emitting near infrared light having a wavelength in the range from about 750 to about 1500 nm, more preferably 750 to 1100 nm, such as a semiconductor laser diode, a Nd:YAG or a Nd:YLF laser. The required laser power depends on the sensitivity of the plate precursor, the pixel dwell time of the laser beam, which is determined by the spot diameter (typical value of modern plate-setters at 1/e² of maximum intensity: 5-25 µm), the scan speed and the resolution of the exposure apparatus (i.e. the number of addressable pixels per unit of linear distance, often expressed in dots per inch or dpi; typical value: 1000-4000 dpi).

After image-wise exposure, the coating may be developed off-press by means of an aqueous alkaline developer. Preferred development compositions are described in WO2017/157570 and a preferred processing apparatus is described in WO2017/157571.

### Light-sensitive printing plate precursors

In addition to the above heat-sensitive printing plate precursors, also light-sensitive printing plate precursors such as UV-sensitive "PS" printing plates and photopolymer printing plates which contain a photopolymerisable and/or photocrosslinkable composition that hardens upon exposure to light, are of interest.

Suitable examples of UV-sensitive "PS" printing plates are sensitive in the range of 300-450 nm (near UV and blue light), and have been discussed in EP1 029 668. Positive compositions based on o-naphtoquinonediazide and negative working compositions based on diazonium salt, a diazonium resin or an aryldiazosulfonate homo- or copolymer; are typically used in "PS" plate precursors.

The light sensitive printing plate precursor based on a photopolymerisation and/or crosslinking reaction contains a coating comprising a layer including a photopolymerisable and/or photocrosslinkable composition, said layer is also referred to as the "photopolymerisable layer". The coating may further include an intermediate layer, located between the support and the photopolymerisable layer, a toplayer and/or optional other layers. The photopolymerisable layer preferably has a coating thickness preferably ranging between 0.2 and 5.0 g/m², more preferably between 0.4 and 3.0 g/m², most preferably between 0.6 and 2.2 g/m2.

The photopolymerisable coating is preferably sensitized to (ultra)violet, visible or IR light. The peak sensitivity of the ultra(violet) composition may be above 420 nm, but a better daylight stability can be obtained with compositions that have their peak sensitivity at shorter wavelength, preferably below 420 nm and more preferably below 410 nm. The availability of laser diodes emitting in the near UV wavelength range, e.g. at 365 or 375 nm, makes compositions having a peak sensitivity outside the visible wavelength range, i.e. below 400 nm, particularly advantageous. According to another embodiment, the peak sensitivity of the photopolymerisable coating is in the IR wavelength range, preferably near-IR light having a wavelength from 750 to 1100 nm, and more preferably from 780 to 850 nm.

A preferred photopolymerisable or photocrosslinkable composition includes a polymerisable or crosslinkable compound, an initiator, an (ultra)violet sensitizer and/or infrared sensitizer, and a polymeric binder.

The polymerisable or crosslinkable compound is preferably a monomer or oligomer including at least one terminal ethylenic group, hereinafter also referred to as "free-radical polymerizable monomer", and the polymerization initiator is a compound capable of generating free radicals upon exposure (hereinafter also referred to as "free-radical initiator") optionally in the presence of a sensitizer.

Suitable free-radical polymerisable monomers or oligomers include, for example, multifunctional (meth)acrylate monomers such as (meth)acrylate esters of ethylene glycol, trimethylolpropane, pentaerythritol, ethoxylated ethylene glycol and ethoxylated trimethylolpropane, multifunctional urethanated (meth)acrylate, and epoxylated (meth)acrylate), and oligomeric amine diacrylates. The (meth)acrylic monomers may also have another double bond or epoxide group in addition to the (meth)acrylate group. The (meth)acrylate monomers may also contain an acidic (such as carboxylic acid) or basic (such as amine) group. Suitable free-radical polymerisable monomers are disclosed in [0042] and [0050] of EP2916171.

Suitable free-radical initiators are described in e.g. WO2005/111727 from page 15 line 17 to page 16 line 11, in EP1091247A and in EP3594009A. Preferred free-radical initiators are for example hexaaryl-bisimidazole compound (HABI; dimer of triarylimidazole), aromatic ketones, organic peroxides, thio compounds, keto-oxime ester compounds, borate compounds, azinium compounds, metallocene compounds, active ester compounds and compounds having a carbon-halogen bond.

A preferred free-radical initiator is an optionally substituted trihaloalkyl sulfone compound (referred to hereafter as "THS" compound) wherein halo independently represents bromo, chloro or iodo and sulfone is a chemical compound containing a sulfonyl group (-SO₂-) attached to two carbon atoms. More preferably, the THS compound is an optionally substituted trihaloalkyl-(hetero)aryl sulfone, i.e. a compound wherein the sulfonyl group is attached to an optionally substituted trihaloalkyl group and to an optionally substituted aryl or optionally substituted heteroaryl group. The aryl group is preferably an optionally substituted phenyl, benzyl, tolyl or an ortho- meta- or para-xylyl, naphthyl, anthracenyl, phenanthrenyl, and/or combinations thereof. The heteroaryl group is preferably an optionally substituted monocyclic or polycyclic aromatic ring comprising carbon atoms and one or more heteroatoms in the ring structure, preferably 1 to 4 heteroatoms independently selected from nitrogen, oxygen, selenium and sulfur. Preferred examples thereof include furan, thiophene, pyrrole, pyrazole, imidazole, 1,2,3- or 1,2,4-triazole, tetrazole, oxazole, isoxazole, thiazole, isothiazole, thiadiazole, oxadiazole, pyridine, pyridazine, pyrimidine, pyrazine, 1,3,5-, 1,2,4- or 1,2,3-triazine, benzofuran, benzothiophene, indole, indazole, benzoxazole, quinoline, quinazoline, benzimidazole or benztriazole. The most preferred THS compound is an optionally substituted tribromomethyl-aryl sulfone, most preferably an optionally substituted tribromomethyl-phenyl sulfone.

The amount of the THS-initiator typically ranges from 0.1 to 30 wt.%, preferably from 0.5 to 10 wt.%, most preferably from 2 to 7 wt.% relative to the total dry weight of the non-volatile components of the photopolymerisable or photocrosslinkable composition.

Another group of preferred free-radical initiators are onium salts, in particular iodonium salts and sulfonium salts or mixtures thereof. Suitable classes of iodonium salts are optionally substituted diaryl iodonium salts or diheteroaryl iodonium salts. Specific examples of the diaryliodonium salts include diphenyliodonium, 4-methoxyphenyl-4-(2-methylpropyl) phenyliodonium, 4-chlorophenyl-4-phenyliodonium, 4- (2-methylpropyl) phenyl- tolyl iodonium, 4-hexyloxyphenyl-2,4,6-trimethoxyphenyliodonium, 4-hexyloxyphenyl-2,4-diethoxyphenyliodonium, 4-octyloxyphenyl- 6-trimethoxyphenyliodonium, bis (4-tert-butylphenyl) iodonium and bis (4-isopropylphenyl) iodonium, 4-octyloxyphenyl phenyliodonium, [4-[(2-hydroxytetradecyl)-oxy]phenyl]phenyliodonium, 4-methylphenyl-4'-hexylphenyliodonium tetra phenyl borate, 4-methylphenyl-4'-cyclohexylphenyliodonium, 4-hexylphenyl-phenyliodonium, 4-methylphenyl-4'cyclohexylphenyliodonium, 4-cyclohexylphenyl-phenyliodonium, 2-methyl-4-t-butylphenyl-4'-methylphenyliodonium, (4-tert-butyl-phenyl)-(4-methoxy-phenyl) iodonium, phenyl-(4-tert-butyl-phenyl) iodonium, phenyl-(4-cumyl-phenyl) iodonium, phenyl-(3-cumyl-phenyl) iodonium and/or mixtures thereof.

Preferred examples of the triarylsulfonium salts include triphenylsulfonium, dialkylphenacylsulfonium, dialkyl-4-hydroxyphenylsulfonium, bis (4-chlorophenyl) phenylsulfonium, triphenylsulfonium benzoyl formate, bis (4-chlorophenyl) phenylsulfonium benzoyl formate, bis (4-chlorophenyl) -4-methylphenylsulfonium bis (4-chlorophenyl) -4-methylphenylsulfonium, tris (4-chlorophenyl) sulfonium, tris 2,4-dichlorophenyl) sulfonium, bis (2,4-dichlorophenyl) phenyl sulfonium and bis (2,4-dichlorophenyl) 4-methoxyphenyl sulfonium.

Suitable counter ions of the onium salts are for example PF₆⁻, SbF₆⁻, AsF₆⁻ and organoboron anions, more preferably optionally substituted tetraphenylborate anions. The onium salts are preferably present in the image recording layer in an amount between 1 and 25 wt.%, more preferably in an amount between 5 and 20 wt.%, and most preferably in an amount between 10% and 16 wt.%.

The photopolymerisable or photocrosslinkable layer may also comprise a co-initiator which is used in combination with a free-radical initiator. Suitable co-initiators are disclosed in US6,410,205; US5,049,479; EP1079276, EP107792, EP1369232, EP1369231, EP1341040, US2003/0124460, EP1241002, EP1288720 and in the reference book including the cited references: Chemistry & Technology UV & EB formulation for coatings, inks & paints - Volume 3 - Photoinitiators for Free Radical and Cationic Polymerization by K.K. Dietliker - Edited by P.K.T. Oldring (1991; ISBN 0947798161). Preferred co-initiators are disclosed in EP2916171A (par. [0051]). A highly preferred co-initiator is a tetra phenyl borate, which may be added as a salt, e.g. sodium or potassium tetraphenyl borate, or as the counter ion of another ingredient such as the onium initiators described above.

Suitable (ultra)violet sensitizers are dyes having a light absorption peak in the wavelength range from 320 nm to 500 nm, preferably from 350 to 450 nm and more preferably from 360 to 420 nm. Suitable (near-)infrared sensitizers are dyes having a light absorption peak in the wavelength range from 750 to 1100 nm, preferably from 780 to 850 nm and more preferably from 810 to 830 nm. The best daylight stability is achieved with sensitizers that have an absorption peak below 400 nm and/or above 750 nm. The mentioned absorption peak wavelengths are values as measured in the dry matrix of the imageable coating of the plate precursor.

Suitable (ultra)violet sensitizers are disclosed in e.g. EP 1349006. Preferred classes of (ultra)violet sensitizers are fluorenes, thioxanthones, (keto-)coumarines, pyrilium or thiopyrilium dyes. More preferred dyes have the general structure Sty-Ar-Sty wherein each "Sty" group is an optionally substituted styryl (C₆H₅-CH=CH-) group and Ar is an optionally substituted aromatic or an optionally substituted heteroaromatic group which forms a conjugated system with the Sty groups. The two Sty groups may be the same of different. Examples of Ar are preferably derived from benzene, naphthalene, anthracene, fluorene, biphenyl, carbazole, furan, dibenzofuran, thiophene, dibenzothiophene, dithienothiophene, oxadiazole, thiadiazole, pyridine, pyrimidine and combinations of two or more of these groups which may be the same or different. Dyes wherein Ar is biphenyl or phenyl are the most preferred. Suitable examples of such distyryl-biphenyl compounds and distyryl-benzene compounds are disclosed in WO2005/029187 and WO2008/145528.

Suitable near-IR sensitizers include IR light absorbing dyes and pigments. A preferred pigment is carbon black. A preferred IR-dye has a light absorption peak between 750 nm and 1300 nm, more preferably between 780 nm and 1100 nm, and most preferably between 800 nm and 850 nm. Suitable IR-dyes are merocyanines, indoanilines, oxonoles, pyrilium dyes, squarilium dyes and cyanine dyes, in particular heptamethine cyanine dyes. Examples of suitable IR-dyes are described in e.g. EP823327, EP978376, EP1029667, EP1053868, EP1093934; EP1359008; WO97/39894 and WO00/29214. Highly preferred IR-dyes produce a visible image immediately upon the image-wise exposure, e.g. those disclosed in EP1736312, EP1910082 and WO2019/219560. Such thermochromic IR-dyes can also be used in the overcoat.

Also mixtures of sensitizers can be used, e.g. mixtures of two or more of the above mentioned dyes, or mixtures of the above dyes with other sensitizers. The overall concentration of the sensitizer(s) with respect to the total dry weight of the image recording layer is preferably from 0.25 to 25.0 wt.%, more preferably from 0.5 to 20.0 wt.% and most preferably from 1.0 to 10.0 wt.%.

The binder can be selected from a wide series of organic polymers. Mixtures of different binders can also be used. Useful binders are described in WO2005/111727 page 17 line 21 to page 19 line 30, EP1043627 in paragraph [0013] and in WO2005/029187 page 16 line 26 to page 18 line 11. Specific examples of binders are described in US 6,899,994; US 2004/0260050, US 2005/0003285, US 2005/0170286, US 2005/0123853 and EP2916171 in [0029], [0030] and [0031]. Other suitable binders as described in EP2471655, EP2492748 and EP2660068 include multifunctional thiols having 6 to 10 functional groups as a nucleus (central skeleton) and polymer chains connected to the nucleus through sulfide bonds. In addition, the image recording layer may optionally comprise one or more co-binders. Typical co-binders are water-soluble or water-dispersible polymers, such as, cellulose derivatives, polyvinylalcohol, polyacrylic acid poly(meth)acrylic acid, polyvinylpyrrolidone, polylactide, polyvinylphosphonic acid, synthetic co-polymers, such as co-polymers of an alkoxy polyethylene glycol (meth)acrylate. Specific examples of co-binders are described in US 2004/0260050, US 2005/0003285 and US 2005/0123853.

The photopolymerisable or photocrosslinkable coating may include discrete particles, i.e. particulate shaped polymers including homopolymers or copolymers prepared from monomers such as ethylene, styrene, vinyl chloride, methyl acrylate, ethyl acrylate, methyl methacrylate, ethyl methacrylate, acrylonitrile, vinyl carbazole, acrylate or methacrylate, or mixtures thereof. Preferably the discrete particles are particles which are suspended in the photopolymerisable composition. The presence of discrete particles tends to promote developability of the non-image areas.

The photopolymerisable or photocrosslinkable coating may include thermally reactive polymer fine particles including a thermally reactive group such as an ethylenically unsaturated group, a cationic polymerizable group, an isocyanate group, an epoxy group, a vinyloxy group, and a functional group having an active hydrogen atom, a carboxy group, a hydroxy group, an amino group or an acid anhydride. The average particle diameter of the polymer fine particle is preferably 0.01 µm to 3.0 µm. Particulate polymers in the form of microcapsules, microgels or reactive microgels are suitable as disclosed in EP1132200; EP1724112 and US2004/106060.

The photopolymerisable or photocrosslinkable coating may also comprise particles which increase the resistance of the coating against manual or mechanical damage such as for example inorganic particles, organic particles or fillers such as described in for example US 7,108,956. In addition, spacer particles may be added to the coating. More details of suitable spacer particles described in EP 2 916 171 [0053] to [0056]. The spacer particles may be substituted with one or more reactive groups.

The photopolymerisable or photocrosslinkable coating may also comprise an inhibitor as disclosed in for example US 6,410,205, EP 1 288 720 and EP 1 749 240.

The photopolymerisable or photocrosslinkable coating may further comprise an adhesion promoting compound. The adhesion promoting compound is a compound capable of interacting with the support, preferably a compound having an addition-polymerizable ethylenically unsaturated bond and a functional group capable of interacting with the support. Under "interacting" is understood each type of physical and/or chemical reaction or process whereby, between the functional group and the support, a bond is formed which can be a covalent bond, an ionic bond, a complex bond, a coordinate bond or a hydrogen-bond, and which can be formed by an adsorption process, a chemical reaction, an acid-base reaction, a complex-forming reaction or a reaction of a chelating group or a ligand. The adhesion promoting compounds described in EP 2 916 171 [0058] are suitable compounds.

Various surfactants may be added into the photopolymerisable or photocrosslinkable coating to allow or enhance the developability of the precursor; especially developing with a gum solution. Both polymeric and small molecule surfactants for example nonionic surfactants are preferred. More details are described in EP 2 916 171 [0059].

The ingredients described above which are present in the photopolymerisable coating may be present in the photopolymerisable layer, the optional intermediate layer, the optional toplayer and/or optional other layers.

The optional toplayer, overcoat or protective overcoat layer preferably acts as an oxygen barrier layer including water-soluble or water-swellable binders. Printing plate precursors which do not contain a toplayer or protective overcoat layer are also referred to as overcoat-free printing plate precursors. The toplayer preferably increases the sensitivity of the printing plate by reducing quenching by oxygen of the free radicals which are generated in the image recording layer by the image-wise exposure.

A toplayer is preferably easily removable during development, adheres sufficiently to the photopolymerisable layer or optional other layers of the coating and preferably does not inhibit the transmission of light during exposure. The overcoat is preferably easily removable during development and preferably adheres well to the photopolymerisable layer or an optional other layers of the coating. The overcoat is preferably soluble or dispersible in water or ink so that it can be removed easily by an aqueous developer or by the dampening solution during on-press development. As a result, the overcoat preferably comprises a hydrophilic binder. Preferred binders which can be used in the top layer are disclosed in WO2005/029190 (page 36 line 3 to page 39 line 25), US 2007/0020563 (paragraph [0158]) and EP1288720A (paragraphs [0148] and [0149]), including the references cited in these patent applications.

The most preferred binder for the toplayer is polyvinylalcohol. The polyvinylalcohol has preferably a hydrolysis degree ranging between 74 mol % and 99 mol %, more preferably between 88-98%. The weight average molecular weight of the polyvinylalcohol can be measured by the viscosity of an aqueous solution, 4 % by weight, at 20°C as defined in DIN 53 015, and this viscosity number ranges preferably between 2 and 26, more preferably between 2 and 15, most preferably between 2 and 10.

A mixture of hydrophilic binders may also be used, for example a mixture of two or more water-soluble polymers such as a combination of poly(vinyl alcohol) and poly(vinyl pyrrolidone), or a mixture of poly(vinyl alcohol)s and/or derivatives of poly(vinyl alcohol)s having a different hydrolysis and viscosity number. Modified poly(vinyl alcohol), e.g. poly(vinyl alcohol) having a carboxyl group and/or a sulfonic acid group may also be used, preferably together with unmodified poly(vinyl alcohol).

The toplayer may include a halogenated polymer which is preferably a hydrophobic polymer, i.e. not soluble or swellable in water at about neutral pH. This binder - as disclosed in EP3587112 and EP3587113 - may be used in the form of a dispersion, i.e. an emulsion or suspension. The amount of the halogenated polymer may be between 30 wt.% and 96 wt.% versus the total dry weight of the overcoat, more preferably between 40 wt.% and 90 wt.% and most preferably between 50 wt.% and 85 wt.%. The halogenated binder preferably includes between 60 wt.% and 95 wt.% of monomeric units derived from vinylidene monomers such as vinylidene fluoride, vinylidene chloride, vinylidene bromide and/or vinylidene iodide.

The toplayer may comprise other ingredients such as anionic surfactants, e.g. sodium alkyl sulfate or sodium alkyl sulfonate, sodium dioctylsulfosuccinate, sodium dodecylbenzenesulfonate, and ammoniumlaurylsulfate; amphoteric surfactants, e.g. alkylaminocarboxylate and alkylamino-dicarboxylate; non-ionic surfactants, e.g. polyethylene glycol, polypropylene glycol, and copolymer of ethylene glycol and propylene glycol, polysiloxane surfactants, perfluorocarbon surfactants, alkylphenyl ethylene oxide condensate, alkoxylated alkylene diamines disclosed in EP1085380 (paragraph [0021] and [0022]); and various additives such as glycerine, pigments, matting agents or wetting agents as disclosed in EP2916171, (in)organic acids, e.g. the acids disclosed in EP2149071 page 27 lines 1 to 21, colorants and/or printing out agents. Also microparticles may be added to the overcoat, for example to reduce the tackiness or moisture sensitivity of the plate.

In a highly preferred embodiment of the plate precursor used in the present invention, the toplayer further comprises a thermochromic dye which produces a visible image upon image-wise exposure with IR light, as disclosed in WO2019/219560.

The coating thickness of the toplayer is preferably between 0.10 and 1.75 g/m², more preferably between 0.20 and 1.3 g/m², and most preferably between 0.25 and 1.0 g/m². In a more preferred embodiment of the present invention, the optional toplayer has a coating thickness between 0.25 and 1.75 g/m² and comprises a polyvinylalcohol having a hydrolysis degree ranging between 74 mol % and 99 mol % and a viscosity number as defined above ranging between 3 and 26.

The plate precursor may be image-wise exposed to UV, violet or IR light, preferably by means of a laser. The UV and violet light is preferably radiation having a wavelength in the range from 350 to 450 nm, more preferably from 360 to 420 nm and most preferably from 400 to 410 nm. Preferred UV and violet lasers are laser diodes, in particular a gallium-nitride diode, emitting at 375 nm or 405 nm respectively. Also a frequency-doubled gallium arsenide diode emitting at 410 nm can be used. The IR light is preferably near-IR radiation having a wavelength in the range from 750 to 1100 nm, more preferably from 780 to 850 nm. Preferred IR lasers are laser diodes emitting at about 830 nm or a Nd:YAG laser emitting at 1064 nm.

The sensitivity of the plate precursor, defined as the energy density of the laser beam measured at the surface of the coating of the plate, which is necessary to produce the lithographic image, is generally between 0.01 and 250 mJ/cm², more preferably between 0.1 and 10 mJ/cm² for plates sensitized to (ultra)violet light and 50 to 200 mJ/cm² for plates sensitized to infrared light. The optimal value for plates of type C is not only dependent on the wavelength but also on the nature and the thickness of the overcoat: a plate with a thin overcoat is less protected against oxygen quenching and therefore requires more energy than a plate with a thick overcoat

After image-wise exposure, the image recording layer may be developed off-press or on-press using similar developers, methods and processors as described above. The optional toplayer is preferably removed together with the non-image areas of the recording layer in a single treatment. Alternatively, a pre-wash step may be carried out to remove the toplayer before subjecting the image recording layer to development. The pre-wash step can be carried out in a stand-alone apparatus or by manually rinsing the plate precursor with water or the pre-wash step can be carried out in a washing unit that is integrated in a processor used for developing the image recording layer. The washing liquid is preferably water, more preferably tap water.

### Examples

The printing plate precursor used is the commercially available Eclipse plate of Agfa Offset BV, Belgium. Eclipse is a "DOP" material comprising an infrared-sensitized photopolymerizable composition. For each press run, 4 printing plates of size 1055mm x 811mm were prepared to address the CMYK printing stations of the press described below. All the printing plates were exposed with the same test image at 2400 dpi by an Avalon N8-90 thermal plate setter using a 200 lpi Agfa Balanced Screening (all commercially available from AGFA NV) at an energy density of 130 mJ/cm².

Plate linearization and calibration curves were setup before platemaking.

Without any off-press processing, the exposed printing plates were mounted on a Heidelberg Speedmaster XL 106 press which was equipped with an automatic AutoPlate plate changing system and an integrated Prinect Inpress Control system (all trademarks of Heidelberg Druckmaschinen, Germany). The latter system automatically carries out the press make-ready process by on-the-fly measurement of the registration and the color data of the printed image, of which the results are used for the repositioning of the plates and adjustment of the ink keys settings as needed. Each print run used K+E Novaboard 4C 1090 Race Bio CMYK inks (trademark of Flint Group) and 3 vol.% of Saphira Fount 221 AF (trademark of Heidelberg Druckmaschinen, Germany) and 6.4 vol.% of isopropanol in water as dampening solution. Coated paper of 115 g/m² was used as receiver material. The printing speed used in all Examples was 13000 sheets per hour. Completion of the press make-ready process was established when the color density of the image was within a ΔE tolerance as defined in ISO standard 12647-2 (2013).

### Printing Results

### Run 1:

500 new, unprinted sheets were placed upside on the paper-input of the press and printing with Image 1 and color bar-01 was started. After printing of about 180 sheets the press make ready process by means of the spectral measurement system Prinect Inpress Control commercially available from Heidelberg was finished and the target color of the image was obtained. The press run was stopped.

### Run 2:

200 new, unprinted sheets were placed upside on the paper-input of the press and the 180 printed sheets of run 1 were placed back, in the same configuration as in run 1, upside, on top of these new sheets. Printing with Image 2 and color bar-02 was started. Color bar-01 was deactivated by exposing a deactivation image on the printing plate precursor prepared for the black print station - at the position of said color bar on the printed sheets.

Color bar-02 was recognised by the detection device of the printing press and after printing of about 190 sheets the press make ready process by means of the spectral measurement system Prinect Inpress Control commercially available from Heidelberg was finished and the target color of the image was obtained. The press run was stopped and only 190 waste sheets were generated at this point i.e. after run 1 and run 2 together.

### Run 3:

200 new, unprinted sheets were placed upside on the paper-input of the press and the 190 printed sheets of run 2 were placed back upside on top of these new sheets. Printing with Image 3 and color bar-03 was started. Color bar-02 was deactivated by exposing a deactivation image on the printing plate precursors prepared for the black print station - at the position of said color bar on the printed sheets.

Colorbar-03 was recognised by the detection device of the printing press and after printing of about 185 sheets the press make ready process by means of the spectral measurement system Prinect Inpress Control commercially available from Heidelberg was finished and the target color of the image was obtained. The press run was stopped and only 190 waste sheets were generated at this point i.e. after run 1, run 2 and run 3 together.

### Conclusion

During the three runs according to the method of the current invention, in total only about 190 waste sheets were created. Under a standard printing regime, about 555 sheets would have been wasted:
180 sheets for make ready of run 1;
190 sheets for make ready of run 2
185 sheets for make ready of run 3.

In conclusion, by using the method of the current invention a huge paper saving of more than 65% was obtained after the three press runs.

## Claims

1. Method for setting up a lithographic printing press which includes at least one print station having an inking system and a plate cylinder,
the method comprising the steps of
(a) preparing a printing plate precursor by exposing an image in an area of the lithographic printing plate precursor, and a color bar CB-02 outside said area;
(b) mounting the exposed plate precursor on the plate cylinder of the printing press;
(c) carrying out a make-ready process for bringing the printing press to production quality which is defined by target color data on printed copies produced by the printing press, said press make-ready process comprising the steps of
(c-i) feeding a number of sheets through the printing press thereby producing printed copies of the image and of the color bar CB-02;
(c-ii) measuring color data on the printed copies of the color bar and adjusting the inking system in accordance with the difference between the measured color data and the target color data;
(c-iii) repeating step (c-i and c-ii) until the measured color data match the target color data;
wherein the sheets which are fed through the printing press in step (c-i) are sheets which have already been used in the press make-ready process of another print run and include at least a previous color bar CB-01 at a position on the printed copies which is different from the position of the color bar CB-02 exposed in step (a).

2. The method according to claim 1 wherein the color bar CB-01 and the color bar CB-02 are printed on the same side of the sheets.

3. The method according to claims 1 or 2 wherein the color bar CB-01 is deactivated before step c(ii) of the press make-ready process.

4. The method according to claims 1 to 3 wherein the color bar CB-01 is deactivated by exposing in step (a) a deactivation image on the printing plate precursor at a position which corresponds to the position of said color bar on the printed copies.

5. The method according to claim 4 wherein the deactivation image covers the recognition patches of the color bar CB-01.

6. The method according to any of the preceding claims wherein the printing press includes at least four print stations and wherein the color bar CB-01 is deactivated in one of the four print stations.

7. The method according to claims 1 or 2 wherein the color bar CB-01 has been deactivated at the end of the press make-ready process of the previous print run by manual deactivation of the color bar on the printed copies and/or by means of a separate deactivation device.

8. The method according to any of the preceding claims wherein the color bar CB-01 and the color bar CB-02 are oriented along direction (X) parallel to the axis of the plate cylinder of the press.

9. The method according to any of the preceding claims wherein the sheets which are fed through the printing press in step (c-i) are sheets which have already been printed in more than one earlier print run and include at least three color bars.

10. The method according to any of the preceding claims wherein the printing press includes an automatic press control system which comprises an integrated system to detect and to measure color data of the color bar on the printed copy, and to modify said color data on the printed copies by adjusting the inking system.

11. The method according to claim 10 wherein the automatic press control system includes a detection device and a measuring device as two separate devices each provided on a different position on the printing press and wherein the color bar CB-01 is deactivated before detection of the color bar CB-02.

12. The method according to claim 11 wherein the detection device is provided on the printing press between the first and the last printing station and the measuring device is provided on the printing press after the last print station.

13. The method according to any of the preceding claims wherein the printing plate precursor is developed before step (b).

14. The method according to any of the preceding claims wherein the printing plate precursor is developed on the press during the press make-ready process.

15. The method according to claims 13 or 14 wherein the printing plate precursor comprises a photopolymerizable or photocrosslinkable image recording layer.
